# EUROPEAN PATENT APPLICATION

(11) **EP 1 847 509 A2**
(43) Date of publication of application: **24.10.2007**
(21) Application number: 07106490.1
(22) Date of filing: 19.04.2007
(51) Int. Cl.: B81C 1/00

(54) **Mechanical isolation for MEMS devices**

(30) Priority: 20.04.2006 US 379469
(71) Applicant: Honeywell International Inc., Morristown, NJ 07962 (US)
(72) Inventor: Lafond, Peter H., Redmond, WA 98052 (US); Yu, Lianzhong, Redmond, WA 98053 (US)
(74) Representative: Haley, Stephen

(57) **Abstract**

A device and method for isolation of MEMS devices. A device includes a pair of substantially symmetrical wafers, each including a perimeter mounting flange and a cover plate, each cover plate and mounting flange separated by a plurality of tines. The cover plates of the wafers are bonded to the opposite sides of a device layer, and the system may then be bonded to other structures via the mounting flange. A method includes forming tines in a pair of wafers and bonding the wafers to opposite sides of a device layer. An alternative method includes bonding a pair of wafers to a device layer, then etching the isolation features.

## Description

Microelectromechanical System (MEMS) devices are used for various purposes. MEMS devices, such as accelerometers and gyros, are often mounted to another structure in order to measure inertial forces experienced by the structure. Directly mounted MEMS devices are exposed to non-inertial, mechanical, and thermal stresses applied by the structure, which leads the MEMS device to produce inaccurate measurements.

These stresses are reduced by using isolation mechanisms between the MEMS device and the structure. One system and method of isolation mechanisms is given in U.S. Patent No. 6,257,060, titled "COMBINED ENHANCED SHOCK LOAD CAPABILITY AND STRESS ISOLATION STRUCTURE FOR AN IMPROVED PERFORMANCE SILICON MICRO-MACHINED ACCELEROMETER," to Leonardson et al., herein incorporated by reference.

While the Leonardson device is useful, it is not suitable for an electrostatic operated device, for example, nor does it maintain overall device symmetry which is necessary for optimal performance in many sensors. A need exists for an improved and broadly applicable, symmetric isolation structure, integral to the device, which substantially reduces the non-inertial forces that can impinge on the device and cause output errors.

A device and method for isolation of MEMS devices is provided by the present invention. A device according to the present invention includes a pair of substantially identical wafers, each including a perimeter mounting flange and a cover plate, each cover plate and mounting flange separated by a plurality of tines. The cover plates of the wafers are bonded to the opposite sides of a device layer, and the system may then be bonded to other structures with the mounting flange.

A method according to the present invention includes forming tines in a pair of wafers and bonding the wafers to opposite sides of a device layer. An alternative method includes bonding a pair of wafers to a device layer, then etching the isolation features into the outer wafers.

Objects of the invention include reducing non-inertial loads including forces due to thermal expansion effects.

As will be readily appreciated from the foregoing summary, the invention provides an improved device and method for mechanical isolation of MEMS devices.

### IN THE DRAWINGS:

The preferred and alternative embodiments of the present invention are described in detail below with reference to the following drawings:
FIGURE 1 is a DRIE-etched device according to the present invention;
FIGURE 2 is a cross-section of the device of FIGURE 1;
FIGURE 3A is a side cross-sectional view of a mounted device according to the present invention and FIGURE 3B is a partial top view of isolation structures including a shock stop;
FIGURES 4A and B are block diagrams of methods according to the present invention;
FIGURES 5A-5D are side views of the intermediate structures produced by the method of FIGURE 4A;
FIGURES 6A-6E are side views of the intermediate structures produced by the method of FIGURE 4B; and
FIGURE 7 is a cross-section of a combined DRIE-etched and KOH-etched device according to the present invention.

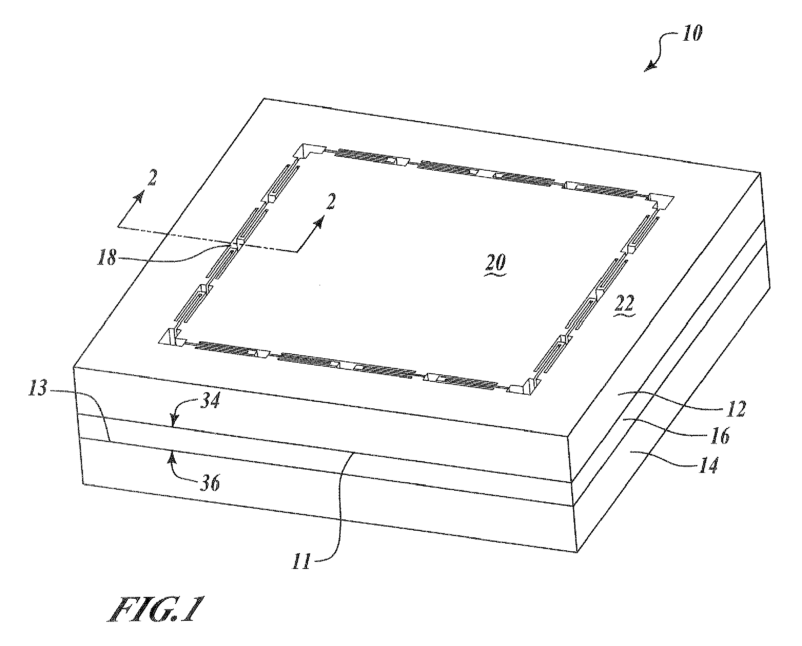

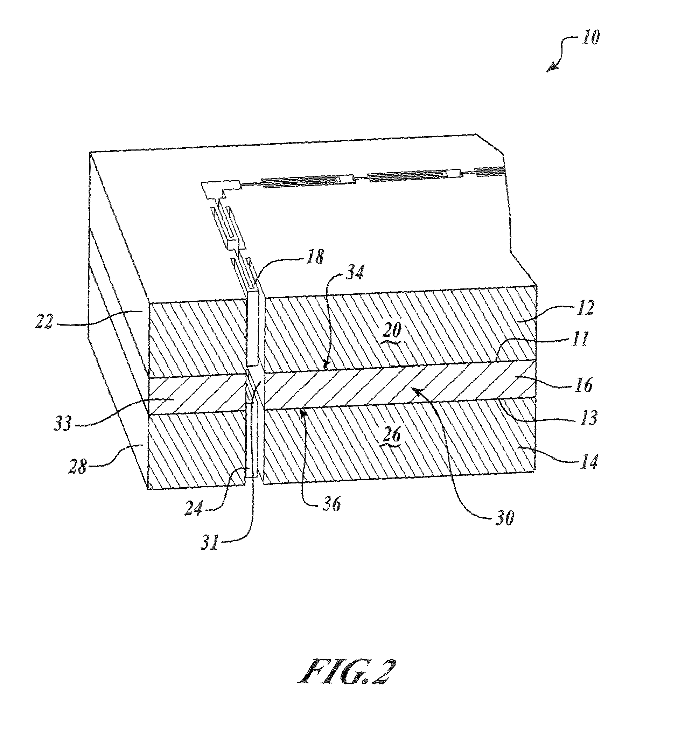

FIGURE 1 shows a device 10 according to the present invention. The device 10 includes a first wafer 12, a second wafer 14, and a device layer 16. The first wafer 12 includes isolation tines 18 extending through the first wafer 12 along a perimeter of the first wafer 12. The isolation tines 18 separate a central cover plate 20 from a perimeter mounting flange 22. The isolation tines 18 can have a variety of flexural shapes. The tines 18 may have a single fold, as shown, or may have more than one fold or may have no folds. The tines 18 may be nested if desired, and may also go around corners. The second wafer 14 is substantially symmetrical to the first wafer 12, and includes isolation structures (shown in FIG. 2) in the form of tines 24, cover plate 26, and perimeter mounting flange 28. The device layer 16 includes a MEMS device 30 (not shown) located between the cover plates 20, 26 of the first and second wafers 12, 14. The first and second wafers 12, 14 and the device layer 16 may include silicon, as well as any other appropriate materials suitable to the application and known to those having skill in the art.

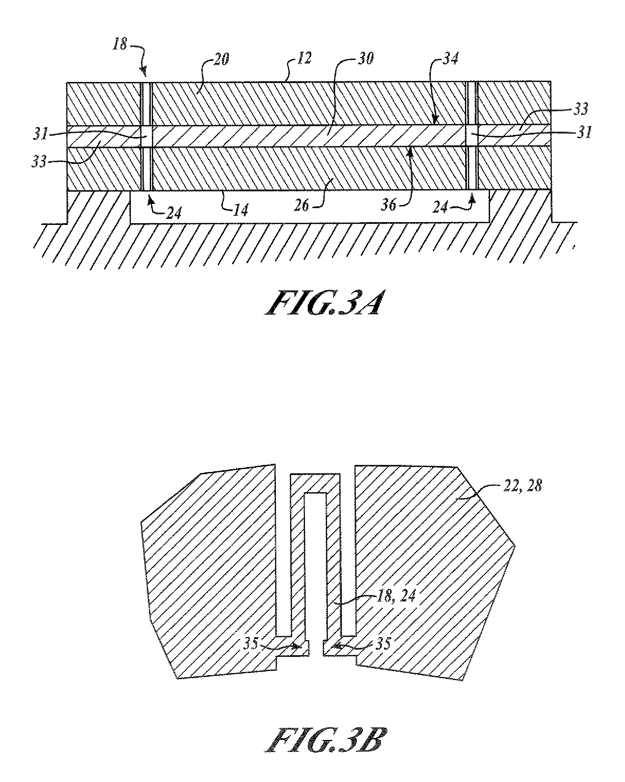

As can be seen in FIGURES 2 and 3A, the device layer 16 includes a gap 31 between the MEMS device 30 and a perimeter 33 of the device layer 16. The gap 31 corresponds to the location of the isolation tines 18, 24 of the first and second wafers 12, 14. The device layer 16 including the MEMS device 30 is bonded on a first surface 34 to the cover plate 20 of the first wafer 12 and on a second surface 36 to the cover plate 26 of the second wafer 14. The MEMS device 30 and the cover plates 20, 26 are thus connected to the perimeter mounting flanges 22, 28 and the device layer perimeter 33 only by the isolation tines 18, 24. Shock stops 35 (FIGURE 3B) may also be formed in the first and second wafers 12, 14 to limit the amount of displacement allowed by the isolation tines 18, 24. This limits the maximum stress in the tines 18, 24 due to a high input acceleration.

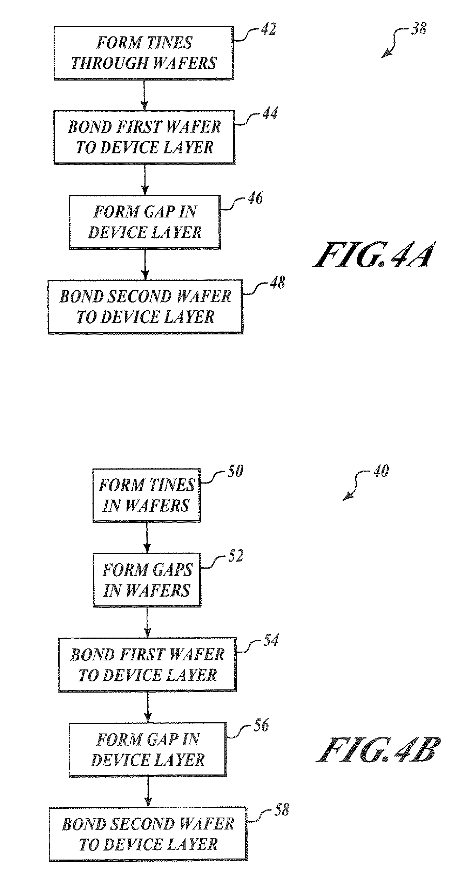

FIGURES 4A and 4B are flow diagrams of methods 38, 40, respectively, according to the present invention. The method 38 of FIGURE 4A may be used to produce the structure 10 shown in FIGURES 1 and 2. First at a block 42, tines 18, 24 are formed through the first and second wafers 12, 14 using DRIE or other etching techniques known to those having skill in the art. Next at a block 44, a first side 11 of the first wafer 12 is bonded to a device layer 16 including a previously formed MEMS device 30. After bonding, a gap 31 is formed in the device layer 16 at a block 46, again using DRIE or other etching techniques. The gap 31 is colocated with the tines 18. After forming the gap 31, a first side 13 of the second wafer 14 is bonded to the device layer 16 at a block 48 so that the tines 24 on the second wafer 14 are colocated with the gap 31.

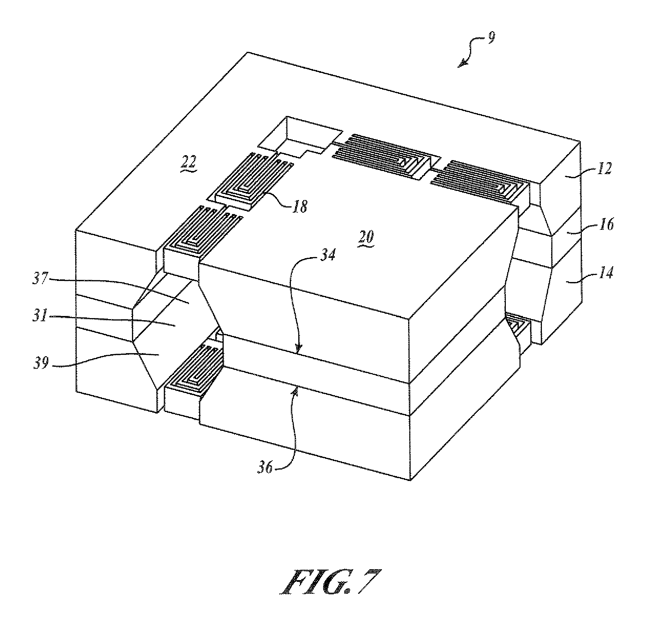

The method 40 of FIGURE 4B may be used to produce the structure 9 shown in FIGURE 7. First, at a block 50, the tines 18, 24 are formed a predetermined depth into the first sides 11, 13 of the first and second wafers 12, 14 using DRIE or other etching methods. After forming the tines 18, 24, KOH etching is initiated from second sides 15, 17 of the first and second wafers 12, 14 to form gaps 37, 39 through the remaining thickness of the first and second wafers 12, 14 at a block 52. At a block 54, the first side 1 of the first wafer 12 is bonded to the device layer 16 using silicon fusion bonding, gold-eutectic bonding, glass frit bonding, epoxy bonding, or other methods known to those having skill in the art. After bonding, a gap 31 is formed in the device layer 16 at a block 56 such that the gap 31 is located between the tines 18, 24. Then at a block 58, the first side 13 of the second wafer 14 is bonded to the device layer 16.

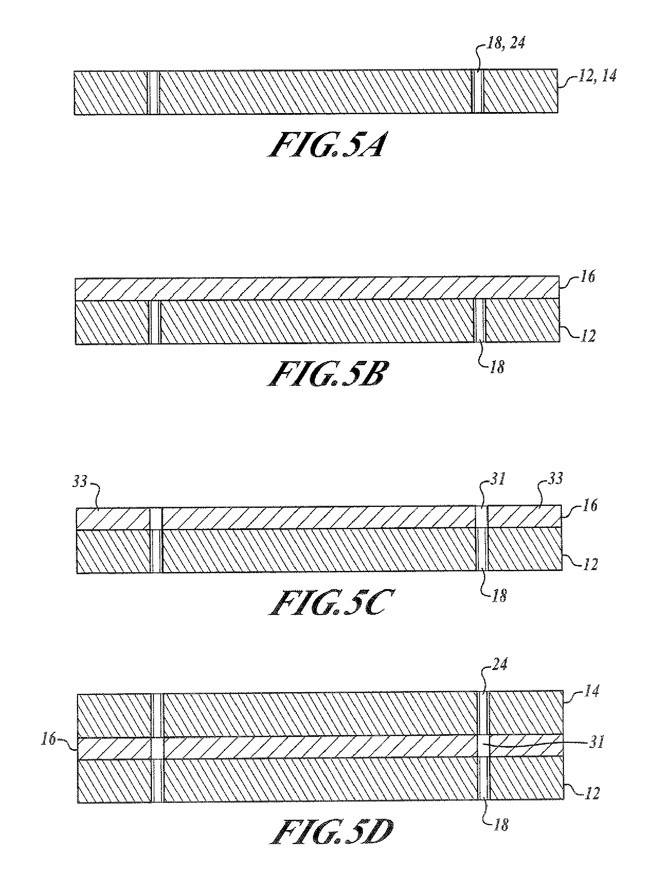

FIGURES 5A-5D show the various intermediate structures created in the method 38 of FIGURE 4A. FIGURE 5A shows first or second wafer 12, 14 with tines 18, 24 formed through the wafer 12, 14. FIGURE 5B shows the first side 11 of the first wafer 12 bonded to the device layer 16 (including the formed MEMS device 30, not shown), FIGURE 5C shows the structure of FIGURE 5B after gaps 31 are formed in the device layer 16. Finally, FIGURE 5D shows the second wafer 14 with the tines 24 bonded to the device layer 16 on the first side 13 of the second wafer 14 such that the gaps 31 are aligned about a vertical axis with the tines 18, 24.

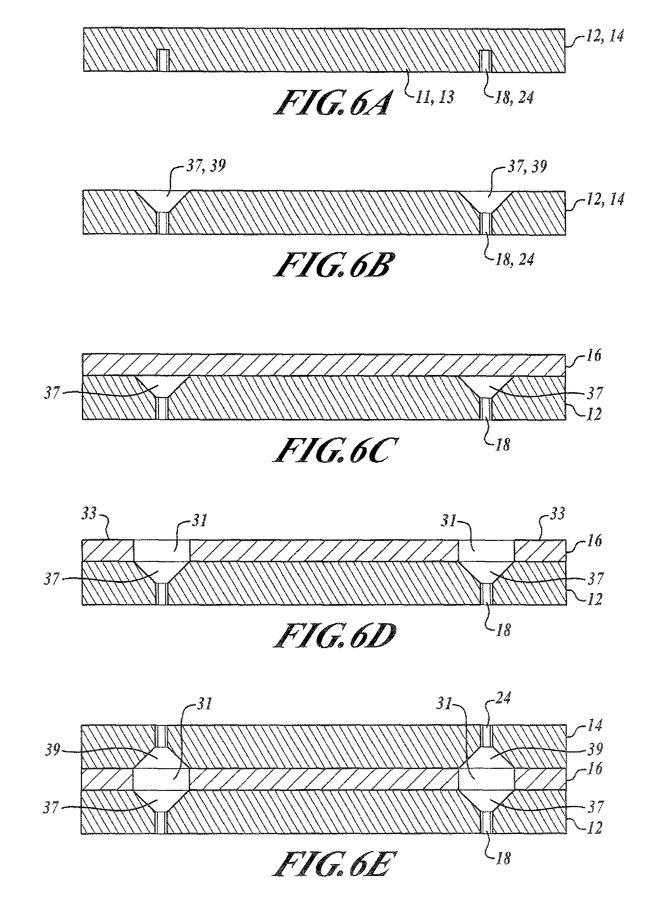

FIGURES 6A-6E show the various intermediate structures created in the method 40 of FIGURE 4B. FIGURE 6A shows the first or second wafer 12, 14 with the tines 18, 24 formed in the wafer 12, 14. FIGURE 6B shows the first or second wafer 12, 14 after gaps 37, 39 are formed through the remaining thickness of the wafer 12, 14. FIGURE 6C shows the device layer 16 bonded to the first side 11 of the first wafer 12. FIGURE 6D shows the structure of FIGURE 6C after the gaps 31 are formed in the device layer 16. FIGURE 6E shows the structure of FIGURE 6D with the first side 13 of the second wafer 14 bonded to the device layer 16.

FIGURE 7 shows a KOH-etched device 9 according to the present invention. The device 9 may also be etched using ethylene diamine pyrocatechol (EDP) or tetra-methyl ammonium hydroxide (TMAH). The device 9 includes isolation tines 18, 24 that do not extend through the first and second wafers 12, 14. Instead, the tines 18, 24 extend partially through the first and second wafers 12, 14 and the gap 31 extends through the device layer 16 and the gaps 37, 39 extend partially through the first and second wafers 12, 14 from the tines 18, 24 to the gap 31 of the device layer 16.

Though the FIGURES show the isolation tines 18, 24 either extending through the wafers 12, 14 or extending from the outer surfaces of the wafers 12, 14 with gaps 31, 35, 37 in between, other configurations are possible. The tines 18, 24 could also be placed adjacent to the device layer 16 with gaps 31, 35, 37 extending from the tines 18, 24 to the outer surfaces of the wafers 12, 14. Also, wet etching could be performed on both sides of the wafers 12, 14, leaving the tines 18, 24 in a center portion of the wafers 12, 14. Thus, the tines 18, 24 may be located anywhere along the thickness of the wafers 12, 14.

While the preferred embodiment of the invention has been illustrated and described, as noted above, many changes can be made without departing from the spirit and scope of the invention. For example, rather than place the isolation tines in the cover plate layers, they could be placed in the device layer with gaps in both the cover layers. Alternately, one could include isolation tines in all three layers. Either of these configurations could be achieved with no significant change in fabrication methods. Accordingly, the scope of the invention is not limited by the disclosure of the preferred embodiment. Instead, the invention should be determined entirely by reference to the claims that follow.

## Claims

1. A device (10) comprising:
a first (12) and second (14) wafer, each wafer including a perimeter mounting flange (22) and a cover plate (20), each cover plate (20) and mounting flange (22) separated by a plurality of isolation structures (18); and,
a device layer (16) bonded to the cover plate (20) of the first wafer (12) on a first side and bonded to the cover plate (20) of the second wafer (14) on a second opposing side.

2. The device (10) of Claim 1, wherein the isolation structures (18) include tines.

3. The device (10) of Claim 1, wherein the device layer (16) includes a microelectromechanical systems (MEMS) device.

4. A method (38) comprising:
forming isolation structures through a first and a second wafer (42), the isolation structures being located between a perimeter mounting flange and an interior cover plate on the first and second wafers;
bonding the first wafer cover plate and mounting flange to a first surface of a device layer including a MEMS device (44);
forming a gap in the device layer (46), the gap location of the gap corresponding to the first wafer isolation structures, the gap isolating a portion of the device layer that corresponds to the cover plate from a portion of the device layer that corresponds to the mounting flange; and
bonding the second wafer cover plate to a second opposing surface of the device layer (48) such that the device layer gap is located between first and second wafer isolation structures.

5. The method (38) of Claim 4, wherein forming isolation structures includes using at least one of Deep Reaction Ion Etching (DRIE) and potassium hydroxide (KOH) etching to form the isolation structures.

6. The method (38) of Claim 5, wherein the wet etching method includes one of Deep Reactive Ion Etching (DRIE), potassium hydroxide (KOH) etching, ethylene diamine pyrocatechol (EDP) etching, or tetra-methyl ammonium hydroxide (TMAH) etching.

7. The method (38) of Claim 4, wherein forming isolation structures includes forming at least one shock stop.

8. A method (40) comprising:
forming isolation structures a predetermined distance in a first and a second wafer (50), the isolation structures defining a perimeter mounting flange and an interior cover plate on the first and second wafers;
forming gaps through the remaining thickness of the first and second wafers (52);
bonding the first wafer cover plate to a first surface of a device layer including a MEMS device (54);
forming a gap in the device layer (56), the gap location of the gap corresponding to the first wafer gap, the gap isolating a portion of the device layer that corresponds to the cover plate from a portion of the device layer that corresponds to the mounting flange; and
bonding the second wafer cover plate to a second opposing surface of the device layer such that the device layer gap corresponds to the second wafer gap (58).

9. The method of Claim 8, wherein forming isolation structures includes using at least one of Deep Reaction Ion Etching (DRIE) and potassium hydroxide (KOH) etching to form the isolation structures.

10. A device comprising:
a first and second wafer, each wafer including a perimeter mounting flange and a cover plate, each cover plate and mounting flange separated by a plurality of isolation structures;
a device layer including a plurality of isolation structures bonded to the cover plate of the first wafer on a first side and bonded to the cover plate of the second wafer on a second opposing side,
wherein the wafer isolation structures and device layer isolation structures may include at least one of tines and gaps.
